# EUROPEAN PATENT APPLICATION

(11) **EP 4 803 956 A1**
(43) Date of publication of application: **09.09.2026**
(21) Application number: 25226854.5
(22) Date of filing: 23.12.2025
(51) Int. Cl.: G02F 1/1345

(54) **DISPLAY DEVICE AND ELECTRONIC DEVICE INCLUDING THE SAME**

(30) Priority: 05.03.2025 KR 20250028460; 05.06.2025 KR 20250073604
(71) Applicant: Samsung Display Co., Ltd., Yongin-si, Gyeonggi-do 17113 (KR)
(72) Inventor: KIM, Hyeon Ji, Yongin-si, Gyeonggi-do (KR)
(74) Representative: Dr. Weitzel & Partner

(57) **Abstract**

A display device includes a display module, a driving circuit on the display module, a circuit board on the display module and having an open area having a portion overlapping the driving circuit, and a buffer protruding in a thickness direction of the circuit board on the circuit board.

## Description

The present invention relates to a display device and an electronic device including the same.

In general, electronic devices, such as smartphones, tablet PCs, digital cameras, laptop computers, navigation systems, and smart TVs include an organic light-emitting display device for displaying images.

Organic light-emitting display devices have advantages, such as excellent luminance, driving voltage, and response speed characteristics and are capable of multicolor expression, and thus have been applied to various products, mainly smartphones. An organic light-emitting display device includes a display module including a plurality of pixels and a circuit unit that supplies signals to the display module.

The display module includes a substrate on which signal lines for delivering signals to realize an image and switching elements for driving the pixels are formed.

The circuit unit includes a system for supplying signals and power for realizing an image, a control circuit board including a controller for converting signals received from the system for supply to the display module, and a driving circuit board including a driving circuit for processing the signals converted by the control circuit board for delivery to the display module.

The present invention provides a display device capable of reducing or preventing damage to a driving circuit due to external impact, and an electronic device including the display device.

The invention is defined by the features of claim 1. The dependent claims and the description provide preferred embodiments.

The present invention is not limited to the aspect mentioned above, and other aspects not explicitly stated will become apparent to those skilled in the art based on the following description.

According to the present invention, a display device includes a display module, a driving circuit on the display module, a circuit board on the display module and having an open area having a portion overlapping the driving circuit, and a buffer protruding in a thickness direction of the circuit board on the circuit board. The buffer may also be termed as a buffer member.

The display device may further include a coupler for coupling the display module and the circuit board, wherein the open area includes a first open area overlapping the driving circuit, and a second open area overlapping the coupler. The coupler may also be termed as a coupler member or coupling member.

The coupler may be connected to the circuit board within the second open area.

The display device may further include buffers spaced apart from each other with the first open area therebetween.

The first open area may extend in one direction, wherein one of the buffers is on one side of the first open area in the one direction, and another one of the buffers is on another side of the first open area in the one direction.

The one direction may correspond to a length direction of the driving circuit.

The buffer may surround a circumference of the first open area in plan view.

The display device may further include a cover on the circuit board to cover the driving circuit, the coupler, the buffer, and at least a portion of the open area. The cover may also be termed as a cover member.

The cover may extend from the display module to the circuit board.

The cover may entirely cover the first open area to cover the driving circuit, and covers at least a portion of the second open area to cover the coupler.

The display device may further include a heat dissipator overlapping the driving circuit and on the cover to be covered by the cover. The heat dissipator may also be termed as a heat dissipation member.

The heat dissipator may be spaced apart from the driving circuit in the thickness direction of the circuit board.

The display device may further include an auxiliary buffer overlapping the driving circuit, and on the cover to be covered by the cover.

The auxiliary buffer may be spaced apart from the driving circuit in the thickness direction of the circuit board.

The display device may further include a circuit cover overlapping the driving circuit, and within the first open area. The circuit cover may also be termed as a circuit cover member.

The circuit cover may correspond to the first open area and entirely covers the entire first open area.

The circuit cover may contact the driving circuit.

The display device may further include an adhesive between the circuit board and the display module to attach the circuit board and the display module to each other. The adhesive er may also be termed as an adhesive member.

According to an aspect of the present invention, an electronic device includes a display module, a driving circuit on the display module, a circuit board on the display module and having an open area formed such that a portion of the open area overlaps the driving circuit, and a buffer protruding in a thickness direction of the circuit board on the circuit board. In other words, the electronic device may include a display device according to the present invention.

The electronic device may further include a processor, a memory configured to store data of at least one of the display module or the processor, and a power module configured to supply power to the display module, the processor, and the memory.

According to the display device and the electronic device including the same of the present invention, by providing, on a circuit board, a buffer protruding in the thickness direction of the circuit board, it is possible to reduce or prevent damage to a driving circuit from external impact.

The aspects according to the embodiments of the present invention are not limited to those mentioned above and more various aspects are included in the following description of the present invention.

The above and other aspects of the present invention will become more apparent by describing example embodiments thereof in detail with reference to the attached drawings, in which:
FIG. 1 is a plan view illustrating a display module of a display device in an unbent state according to first one or more embodiments of the present invention;
FIG. 2 is a plan view illustrating the display module in a bent state from the state illustrated in FIG. 1;
FIG. 3 is a partial side view illustrating the display device in FIG. 1;
FIG. 4 is a cross-sectional view illustrating a display panel of the display module in FIG. 1;
FIG. 5 is an enlarged plan view of portion A in FIG. 2;
FIG. 6 is a cross-sectional view taken along the line I1-I1' of FIG. 5;
FIG. 7 is a plan view illustrating a display module of a display device in a bent state according to second one or more embodiments of the present invention;
FIG. 8 is an enlarged plan view of portion B in FIG. 7;
FIG. 9 is a cross-sectional view taken along the line I2-I2' of FIG. 8;
FIG. 10 is a plan view illustrating a state in which a cover is placed in the display device in FIG. 7;
FIG. 11 is an enlarged plan view of portion C in FIG. 10;
FIG. 12 is a cross-sectional view taken along the line I3-I3' of FIG. 11;
FIG. 13 is a cross-sectional view illustrating a state in which a heat dissipator is placed in the display device in FIG. 12;
FIG. 14 is a cross-sectional view illustrating a state in which an auxiliary buffer is placed in the display device in FIG. 12;
FIG. 15 is a cross-sectional view illustrating a state in which a circuit cover and an adhesive are placed in the display device in FIG. 12;
FIG. 16 is a block diagram of an electronic device according to one or more embodiments of the present invention; and
FIG. 17 illustrates schematic views of electronic devices according to various embodiments of the present invention.

Aspects of some embodiments of the present invention and methods of accomplishing the same may be understood more readily by reference to the detailed description of embodiments and the accompanying drawings. The described embodiments are provided as examples so that this disclosure will be thorough and complete, and will fully convey the aspects of the present invention to those skilled in the art. Accordingly, processes, elements, and techniques that are redundant, that are unrelated or irrelevant to the description of the embodiments, or that are not necessary to those having ordinary skill in the art for a complete understanding of the aspects of the present invention may be omitted. Unless otherwise noted, like reference numerals, characters, or combinations thereof denote like elements throughout the attached drawings and the written description, and thus, repeated descriptions thereof may be omitted.

The described embodiments may have various modifications and may be embodied in different forms, and should not be construed as being limited to only the illustrated embodiments herein. The use of "can," "may," or "may not" in describing one or more embodiments corresponds to one or more embodiments of the present invention.

A person of ordinary skill in the art would appreciate, in view of the present invention, that each suitable feature of the various embodiments of the present invention may be combined or combined with each other, partially or entirely, and may be technically interlocked and operated in various suitable ways, and each embodiment may be implemented independently of each other or in conjunction with each other in any suitable manner unless otherwise stated or implied.

In the drawings, the relative sizes of elements, layers, and regions may be exaggerated for clarity and/or descriptive purposes. In other words, because the sizes and thicknesses of elements in the drawings are arbitrarily illustrated for convenience of description, the invention is not limited thereto. Additionally, the use of cross-hatching and/or shading in the accompanying drawings is generally provided to clarify boundaries between adjacent elements. As such, neither the presence nor the absence of cross-hatching or shading conveys or indicates any preference or requirement for particular materials, material properties, dimensions, proportions, commonalities between illustrated elements, and/or any other characteristic, attribute, property, etc., of the elements, unless specified.

Various embodiments are described herein with reference to sectional illustrations that are schematic illustrations of embodiments and/or intermediate structures. As such, variations from the shapes of the illustrations as a result of, for example, manufacturing techniques and/or tolerances, are to be expected. Further, specific structural or functional descriptions disclosed herein are merely illustrative for the purpose of describing embodiments according to the concept of the present invention. Thus, embodiments disclosed herein should not be construed as limited to the illustrated shapes of elements, layers, or regions, but are to include deviations in shapes that result from, for instance, manufacturing.

For example, an implanted region illustrated as a rectangle will, typically, have rounded or curved features and/or a gradient of implant concentration at its edges rather than a binary change from implanted to non-implanted region. Likewise, a buried region formed by implantation may result in some implantation in the region between the buried region and the surface through which the implantation takes place.

Spatially relative terms, such as "beneath," "below," "lower," "lower side," "under," "above," "upper," "over," "higher," "upper side," "side" (e.g., as in "sidewall"), and the like, may be used herein for ease of explanation to describe one element or feature's relationship to another element(s) or feature(s) as illustrated in the figures. It will be understood that the spatially relative terms are intended to encompass different orientations of the device in use or in operation, in addition to the orientation depicted in the figures. For example, if the device in the figures is turned over, elements described as "below," "beneath," "or "under" other elements or features would then be oriented "above" the other elements or features. Thus, the example terms "below" and "under" can encompass both an orientation of above and below. The device may be otherwise oriented (e.g., rotated 90 degrees or at other orientations) and the spatially relative descriptors used herein should be interpreted accordingly. Similarly, when a first part is described as being arranged "on" a second part, this indicates that the first part is arranged at an upper side or a lower side of the second part without the limitation to the upper side thereof on the basis of the gravity direction.

Further, the phrase "in a plan view" means when an object portion is viewed from above, and the phrase "in a schematic cross-sectional view" means when a schematic cross-section taken by vertically cutting an object portion is viewed from the side. The terms "overlap" or "overlapped" mean that a first object may be above or below or to a side of a second object, and vice versa. Additionally, the term "overlap" may include stack, face or facing, extending over, covering, or partly covering or any other suitable term as would be appreciated and understood by those of ordinary skill in the art. The expression "not overlap" may include meaning, such as "apart from" or "set aside from" or "offset from" and any other suitable equivalents as would be appreciated and understood by those of ordinary skill in the art. The terms "face" and "facing" may mean that a first object may directly or indirectly oppose a second object. In a case in which a third object intervenes between a first and second object, the first and second objects may be understood as being indirectly opposed to one another, although still facing each other.

It will be understood that when an element, layer, region, or component (e.g., an apparatus, a device, a circuit, a wire, an electrode, a terminal, a conductive film, etc.) is referred to as being "formed on," "on," "connected to," or "(operatively, functionally, or communicatively) coupled to" another element, layer, region, or component, it can be directly formed on, on, connected to, or coupled to the other element, layer, region, or component, or indirectly formed on, on, connected to, or coupled to the other element, layer, region, or component such that one or more intervening elements, layers, regions, or components may be present. In addition, this may collectively mean a direct or indirect coupling or connection and an integral or non-integral coupling or connection. For example, when a layer, region, or component is referred to as being "electrically connected" or "electrically coupled" to another layer, region, or component, it can be directly electrically connected or coupled to the other layer, region, and/or component or one or more intervening layers, regions, or components may be present. The one or more intervening components may include a switch, a transistor, a resistor, an inductor, a capacitor, a diode and/or the like. Accordingly, a connection is not limited to the connections illustrated in the drawings or the detailed description and may also include other types of connections. In describing embodiments, an expression of connection indicates electrical connection unless explicitly described to be direct connection, and "directly connected/directly coupled," or "directly on," refers to one component directly connecting or coupling another component, or being on another component, without an intermediate component.

In addition, in the present specification, when a portion of a layer, a film, an area, a plate, or the like is formed on another portion, a forming direction is not limited to an upper direction but includes forming the portion on a side surface or in a lower direction. On the contrary, when a portion of a layer, a film, an area, a plate, or the like is formed "under" another portion, this includes not only a case where the portion is "directly beneath" another portion but also a case where there is further another portion between the portion and another portion. Meanwhile, other expressions describing relationships between components, such as "between," "immediately between" or "adjacent to" and "directly adjacent to," may be construed similarly. It will be understood that when an element or layer is referred to as being "between" two elements or layers, it can be the only element or layer between the two elements or layers, or one or more intervening elements or layers may also be present.

For the purposes of this invention, expressions such as "at least one of," or "any one of," or "one or more of" when preceding a list of elements, modify the entire list of elements and do not modify the individual elements of the list. For example, "at least one of X, Y, and Z," "at least one of X, Y, or Z," "at least one selected from the group consisting of X, Y, and Z," and "at least one selected from the group consisting of X, Y, or Z" may be construed as X only, Y only, Z only, any combination of two or more of X, Y, and Z, such as, for instance, XYZ, XY, YZ, and XZ, or any variation thereof. Similarly, the expressions "at least one of A and B" and "at least one of A or B" may include A, B, or A and B. As used herein, "or" generally means "and/or," and the term "and/or" includes any and all combinations of one or more of the associated listed items. For example, the expression "A and/or B" may include A, B, or A and B. Similarly, expressions such as "at least one of," "a plurality of," "one of," and other prepositional phrases, when preceding a list of elements, modify the entire list of elements and do not modify the individual elements of the list. When "C to D" is stated, it means C or more and D or less, unless otherwise specified.

It will be understood that, although the terms "first," "second," "third," etc., may be used herein to describe various elements, components, regions, layers and/or sections, these elements, components, regions, layers and/or sections should not be limited by these terms. These terms do not correspond to a particular order, position, or superiority, and are only used to distinguish one element, member, component, region, area, layer, section, or portion from another element, member, component, region, area, layer, section, or portion. Thus, a first element, component, region, layer, or section described below could be termed a second element, component, region, layer, or section, without departing from the present invention. The description of an element as a "first" element may not require or imply the presence of a second element or other elements. The terms "first," "second," etc. may also be used herein to differentiate different categories or sets of elements. For conciseness, the terms "first," "second," etc. may represent "first-category (or first-set)," "second-category (or second-set)," etc., respectively.

In the examples, the x-axis, the y-axis, and/or the z-axis are not limited to three axes of a rectangular coordinate system, and may be interpreted in a broader sense. For example, the x-axis, the y-axis, and the z-axis may be perpendicular to one another, or may represent different directions that are not perpendicular to one another. The same applies for first, second, and/or third directions.

The terminology used herein is for the purpose of describing embodiments only and is not intended to be limiting of the present invention. As used herein, the singular forms "a" and "an" are intended to include the plural forms as well, while the plural forms are also intended to include the singular forms, unless the context clearly indicates otherwise. It will be further understood that the terms "comprises," "comprising," "have," "having," "includes," and "including," when used in this specification, specify the presence of the stated features, integers, steps, operations, elements, and/or components, but do not preclude the presence or addition of one or more other features, integers, steps, operations, elements, components, and/or groups thereof.

When one or more embodiments may be implemented differently, a specific process order may be performed differently from the described order. For example, two consecutively described processes may be performed substantially at the same time or performed in an order opposite to the described order.

As used herein, the terms "substantially," "about," "approximately," and similar terms are used as terms of approximation and not as terms of degree, and are intended to account for the inherent deviations in measured or calculated values that would be recognized by those of ordinary skill in the art. For example, "substantially" may include a range of +/- 5 % of a corresponding value. "About" or "approximately," as used herein, is inclusive of the stated value and means within an acceptable range of deviation for the particular value as determined by one of ordinary skill in the art, considering the measurement in question and the error associated with measurement of the particular quantity (i.e., the limitations of the measurement system). For example, "about" may mean within one or more standard deviations, or within ± 30%, 20%, 10%, 5% of the stated value. Further, the use of "may" when describing embodiments of the present invention refers to "one or more embodiments of the present invention." Furthermore, the expression "being the same" may mean "being substantially the same." In other words, the expression "being the same" may include a range that can be tolerated by those of ordinary skill in the art. The other expressions may also be expressions from which "substantially" has been omitted.

In some embodiments well-known structures and devices may be described in the accompanying drawings in relation to one or more functional blocks (e.g., block diagrams), units, and/or modules to avoid unnecessarily obscuring various embodiments. Those skilled in the art will understand that such block, unit, and/or module are/is physically implemented by a logic circuit, an individual component, a microprocessor, a hard wire circuit, a memory element, a line connection, and other electronic circuits. This may be formed using a semiconductor-based manufacturing technique or other manufacturing techniques. The block, unit, and/or module implemented by a microprocessor or other similar hardware may be programmed and controlled using software to perform various functions discussed herein, optionally may be driven by firmware and/or software. In addition, each block, unit, and/or module may be implemented by dedicated hardware, or a combination of dedicated hardware that performs some functions and a processor (for example, one or more programmed microprocessors and related circuits) that performs a function different from those of the dedicated hardware. In addition, in some embodiments, the block, unit, and/or module may be physically separated into two or more interact individual blocks, units, and/or modules without departing from the scope of the present invention. In addition, in some embodiments, the block, unit and/or module may be physically combined into more complex blocks, units, and/or modules without departing from the scope of the present invention.

Unless otherwise defined, all terms (including technical and scientific terms) used herein have the same meaning as commonly understood by one of ordinary skill in the art to which the present invention belongs. It will be further understood that terms, such as those defined in commonly used dictionaries, should be interpreted as having a meaning that is consistent with their meaning in the context of the relevant art and/or the present specification, and should not be interpreted in an idealized or overly formal sense, unless expressly so defined herein.

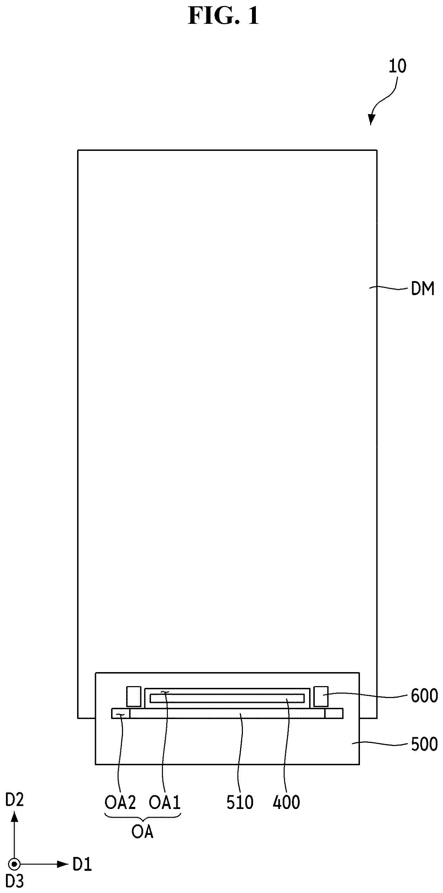

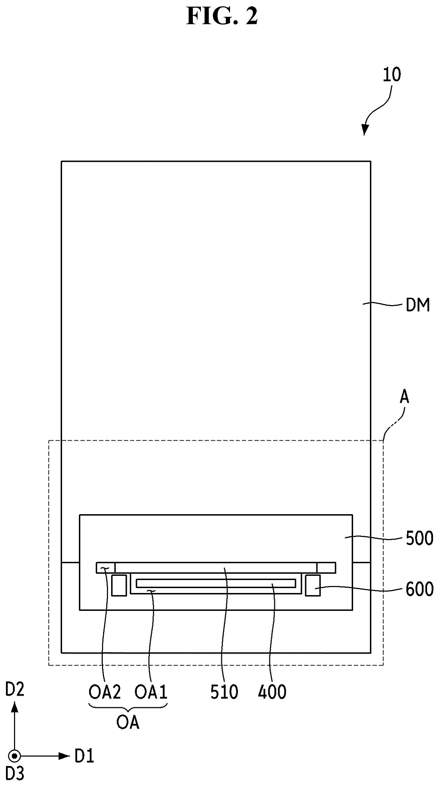

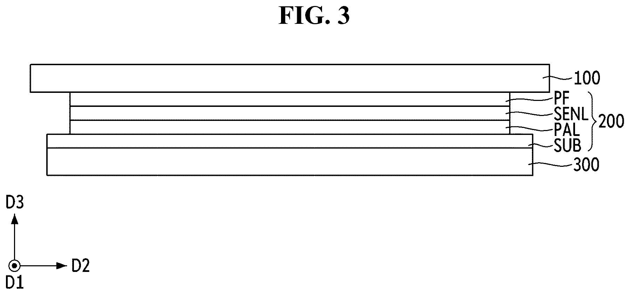

FIG. 1 is a plan view illustrating a display module of a display device in an unfolded state, according to first one or more embodiments of the present invention. FIG. 2 is a plan view illustrating the display module in a bent state from the state illustrated in FIG. 1. FIG. 3 is a partial side view illustrating the display device in FIG. 1.

A display device 10 according to one or more embodiments of the present invention is a device that displays moving images or still images and may be used as a display screen of various products, such as portable electronic devices including a mobile phone, a smart phone, a tablet personal computer, a smart watch, a watch phone, a mobile communication terminal, an electronic notebook, an e-book reader, a portable multimedia player (PMP), a navigation device, or an ultra-mobile PC (UMPC), as well as a television, a laptop computer, a monitor, a billboard, or an internet of things (IoT) device. Alternatively, the display device 10 may be used as a display screen applied to a center fascia of a vehicle.

The display device 10 may be a light-emitting display device, such as an organic light-emitting display device using organic light-emitting diodes, a quantum dot light-emitting display device including a quantum dot light-emitting layer, an inorganic light-emitting display device including an inorganic semiconductor, or a micro light-emitting display device using micro light-emitting diodes (micro LEDs). The display device 10 will hereinafter be described as being an organic light-emitting display device, but the present invention is not limited thereto.

A first direction D1 may be a direction parallel to one side of the display device 10 when viewed on a plane, for example, a horizontal direction of the display device 10. A second direction D2 may be a direction parallel to another side that meets the side corresponding to the first direction D1, and may be a vertical direction of the display device 10. A third direction D3 may be a thickness direction of the display device 10.

The display device 10 may have a rectangular planar shape, such as a quadrangle. For example, the display device 10 may have a rectangular planar shape having short sides in the first direction D1 and long sides in the second direction D2. The corners where the short sides in the first direction D1 and the long sides in the second direction D2 meet may have a curvature (e.g., predetermined curvature) or formed at a right angle. The planar shape of the display device 10 is not limited to a rectangle, and the display device 10 may also be formed as another polygon, a circle, or an ellipse.

The display device 10 may include a display area and a non-display area. The planar shape of the display area may follow the shape of the display device 10. For example, if the planar shape of the display device 10 is rectangular, the planar shape of the display area may also be rectangular.

The display area may be a region that includes a plurality of pixels and displays an image. The non-display area may be a region that does not include pixels and does not display an image. The non-display area may be arranged around the display area. The non-display area may be arranged to surround the display area (e.g., in plan view), but the present invention is not limited thereto. Alternatively, the display area may be partially surrounded by the non-display area.

Referring to FIGS. 1 through 3, the display device 10 may include a display module DM, a driving circuit 400, a circuit board 500, a coupler (e.g., coupling member) 510, and buffers (e.g., buffer members) 600.

The display module DM may include a cover window 100, a display panel 200, and a panel lower member 300.

The cover window 100 may include a material having high light transmittance. The cover window 100 may include a polymer resin, such as polyimide or glass. The cover window 100 may be attached to a polarizing film PF of the display panel 200, which will be described later, by an adhesive (e.g., adhesive member), such as an optically clear adhesive (OCA) film.

The display panel 200 may be positioned below the cover window 100. The display panel 200 may have a rectangular planar shape with short sides in the first direction D1 and long sides in the second direction D2. In the display panel 200, the corners where the short sides in the first direction D1 and the long sides in the second direction D2 meet may be formed at a right angle or may have a curvature (e.g., predetermined curvature). Alternatively, the display panel 200 may have another quadrilateral, another non-quadrilateral polygonal shape, a circular shape, an elliptical shape, or an irregular shape in plan view.

The display panel 200 may include a display area in which a plurality of light-emitting regions that emit light are arranged, and a non-display area arranged around the display area. The non-display area may be arranged to surround the display area. In a portion of the non-display area at one edge of the display panel 200, a plurality of display pads may be arranged.

The display panel 200 may include a substrate SUB, a display unit PAL, a sensor unit SENL, and a polarizing film PF.

The substrate SUB may include an insulating material, such as glass, quartz, or polymer resin. The substrate SUB may be a rigid substrate or a flexible substrate capable of bending, folding, or rolling.

The display unit PAL may be positioned on the substrate SUB (as used herein, "on" may mean "above" or "below"). The display unit PAL may be a layer including a plurality of light-emitting regions that emit light. The display unit PAL may include a buffer layer, a thin-film transistor layer on which thin-film transistors are arranged, a light-emitting element layer that emits light, and an encapsulation layer for encapsulating the light-emitting element layer.

The sensor unit SENL may be positioned on the display unit PAL. The sensor unit SENL may include sensor electrodes and may be a layer for detecting the presence of a user's touch input.

The polarizing film PF may be positioned on the sensor unit SENL. The polarizing film PF may serve to reduce or prevent degradation of image visibility of the display panel 200 caused by reflection of external light. The polarizing film PF may include a linear polarizer and a phase retardation film, such as a quarter-wave (λ/4) plate. The phase retardation film may be positioned on the sensor unit SENL, and the linear polarizer may be positioned on the phase retardation film. The cover window 100 may be positioned above the polarizing film PF.

The panel lower member 300 may be positioned below the substrate SUB. The panel lower member 300 may be attached to a lower surface of the substrate SUB through an adhesive. The adhesive may be a pressure sensitive adhesive (PSA). The panel lower member 300 may include at least one of a light absorber (e.g., light-absorbing member) for absorbing light incident from the outside, a buffer for absorbing external impact, or a heat dissipator (e.g., heat-dissipating member) for efficiently releasing heat from the display panel 200.

The light absorber may be positioned below the substrate SUB. The light absorber reduces or prevents visibility of configurations arranged below the light absorber, such as the circuit board 500, when viewed from above the display panel 200 by blocking light transmission. The light absorber may include a light-absorbing material, such as black pigment or black dye.

The buffer may be positioned below the light absorber. The buffer absorbs external impact and reduces or prevents damage to the display panel 200. The buffer may be formed as a single layer or multiple layers. For example, the buffer may include a polymer resin, such as polyurethane, polycarbonate, polypropylene, or polyethylene, or may include an elastic material, such as rubber, a urethane-based material, or a sponge formed by foaming an acrylic-based material.

The heat dissipator may be positioned below the buffer. The heat dissipator may include a first heat-dissipating layer including graphite or carbon nanotubes, and a second heat-dissipating layer including a metal thin film, such as copper, nickel, ferrite, or silver, which is capable of shielding electromagnetic waves and has excellent thermal conductivity.

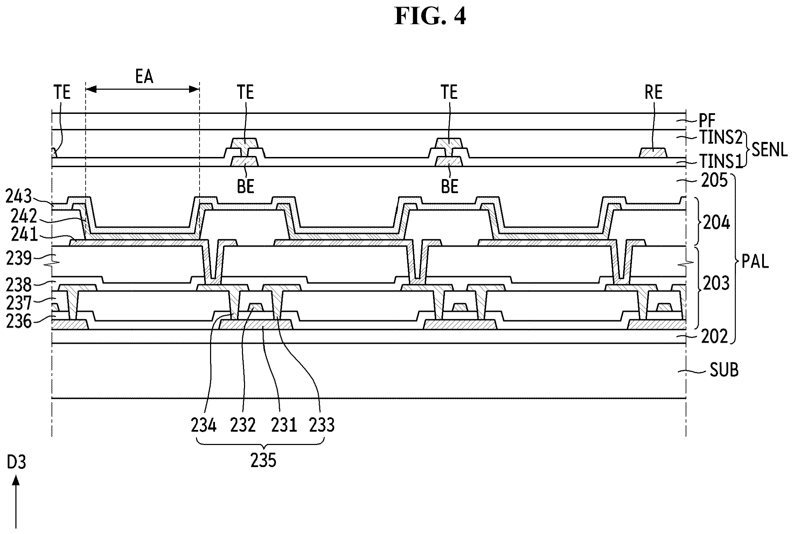

FIG. 4 is a cross-sectional view illustrating the display panel of the display module in FIG. 1.

Referring to FIG. 4, the display unit PAL may include a buffer film 202, a thin-film transistor film 203, a light-emitting element layer 204, and an encapsulation layer 205.

The buffer film 202 may be formed on the substrate SUB. The buffer film 202 may be formed on the substrate SUB to protect the thin-film transistors 235 and light-emitting elements from moisture penetrating the substrate SUB, which is vulnerable to moisture permeation. The buffer film 202 may include a plurality of inorganic films alternately stacked. For example, the buffer film 202 may be formed as a multilayer film in which one or more inorganic films among a silicon oxide (SiOₓ) film, a silicon nitride (SiNₓ) film, and/or a silicon oxynitride (SiON) film are alternately stacked. The buffer film 202 may be omitted.

The thin-film transistor film 203 is formed on the buffer film 202. The thin-film transistor film 203 includes the thin-film transistors 235, a gate-insulating film 236, an interlayer insulating film 237, a passivation film 238, and an organic film 239.

Each of the thin-film transistors 235 includes an active layer 231, a gate electrode 232, a source electrode 233, and a drain electrode 234. In FIG. 4, each of the thin-film transistors 235 is illustrated as having a top gate structure, where the gate electrode 232 is positioned above the active layer 231, but the present invention is not limited thereto. That is, each of the thin-film transistors 235 may also be formed in a bottom gate structure where the gate electrode 232 is positioned below the active layer 231, or in a double gate structure where the gate electrode 232 is positioned both above and below the active layer 231.

The active layers 231 may be formed on the buffer film 202. The active layers 231 may include a silicon-based semiconductor material or an oxide-based semiconductor material. For example, the active layers 231 may include polycrystalline silicon, amorphous silicon, or an oxide semiconductor. A light-shielding layer may be formed between the buffer film 202 and the active layers 231 to block external light from entering the active layers 231.

The gate-insulating film 236 may be formed on the active layers 231. The gate-insulating film 236 may include an inorganic film, such as a silicon oxide film, a silicon nitride film, or a multilayer thereof.

The gate electrodes 232 may be formed on the gate-insulating film 236. The gate electrodes 232 and gate wiring may include a single layer or a multilayer of at least one of molybdenum (Mo), aluminum (Al), chromium (Cr), gold (Au), titanium (Ti), nickel (Ni), neodymium (Nd), or copper (Cu), or an alloy thereof.

The interlayer insulating film 237 may be formed on the gate electrodes 232 and the gate wiring. The interlayer insulating film 237 may include an inorganic film, such as a silicon oxide film, a silicon nitride film, or a multilayer thereof.

The source electrodes 233 and the drain electrodes 234 may be formed on the interlayer insulating film 237. The source electrodes 233 and the drain electrodes 234 may be connected to the active layers 231 through contact holes penetrating the gate-insulating film 236 and the interlayer insulating film 237. The source electrodes 233 and the drain electrodes 234 may include a single layer or a multilayer of at least one of Mo, Al, Cr, Au, Ti, Ni, Nd, or Cu, or an alloy thereof.

The passivation film 238 may be formed on the source electrodes 233 and the drain electrodes 234 to insulate the thin-film transistors 235. The passivation film 238 may include an inorganic film, such as a silicon oxide film, a silicon nitride film, or a multilayer thereof.

The organic film 239 may be formed on the passivation film 238 to planarize step differences caused by the thin-film transistors 235. The organic film 239 may include an organic resin, such as acryl resin, epoxy resin, phenolic resin, polyamide resin, or polyimide resin.

The light-emitting element layer 204 is formed on the thin-film transistor films 203. The light-emitting element layer 204 includes light-emitting elements and a bank.

The light-emitting elements and the bank are formed on the organic film 239. The light-emitting elements are exemplified as organic light-emitting elements including an anode electrodes 241, light-emitting layers 242, and a cathode electrode 243.

The anode electrodes 241 may be formed on the organic film 239. The anode electrodes 241 may be connected to the source electrodes 233 of the thin-film transistors 235 through contact holes penetrating the passivation film 238 and the organic film 239.

The bank may be formed on the organic film 239 to cover the edges of the anode electrodes 241 to define light-emitting areas EA of the pixels. That is, the bank serves to define the light-emitting areas EA of the pixels. Each of the pixels corresponds to an area in which an anode electrode 241, a light-emitting layer 242, and a cathode electrode 243 are sequentially stacked such that holes from the anode electrode 241 and electrons from the cathode electrode 243 recombine in the light-emitting layer 242 to emit light.

The light-emitting layers 242 may be formed on the anode electrodes 241 and the bank. The light-emitting layers 242 may be organic light-emitting layers. The light-emitting layers 242 may emit one of red, green, or blue light. Alternatively, the light-emitting layer 242 may be a white light-emitting layer emitting white light. In this case, the light-emitting layer 242 may have a structure where red, green, and blue light-emitting layers are stacked and may be a common layer formed in common for the pixels, and the display panel 200 may additionally include color filters for displaying red, green, and blue.

The light-emitting layers 242 may each include a hole transport layer, a light-emitting layer, and an electron transport layer. The light-emitting layers 242 may each be formed in a tandem structure of two or more stacks, in which case, a charge generation layer may be formed between the stacks.

The cathode electrode 243 is formed on the light-emitting layers 242. The cathode electrode 243 may cover the light-emitting layers 242. The cathode electrode 243 may be a common layer formed in common for the pixels.

When the light-emitting element layers 204 are formed in a top emission structure emitting light in an upward direction, the anode electrodes 241 may include a highly reflective metal material, such as a stack of aluminum (Al) and titanium (Ti) (e.g., Ti/Al/Ti), a stack of Al and ITO (e.g., ITO/Al/ITO), APC, or a stack of APC and ITO (e.g., ITO/APC/ITO). Here, APC is an alloy of silver (Ag), palladium (Pd), or copper (Cu). In this case, the cathode electrode 243 may include a transparent conductive oxide (TCO), such as ITO or IZO capable of transmitting light therethrough, or a semi-transmissive conductive material, such as magnesium (Mg), Ag, or an alloy thereof. When the cathode electrode 243 includes a semi-transmissive conductive material, light extraction efficiency may be improved through a micro cavity effect.

Conversely, when the light-emitting element layer 204 is formed in a bottom emission structure emitting light in a downward direction, the anode electrodes 241 may include a TCO, such as ITO or IZO, or a semi-transmissive conductive material, such as Mg, Ag, or an alloy thereof. The cathode electrode 243 may include a highly reflective metal material, such as a stack of Al and Ti (e.g., Ti/Al/Ti), a stack of Al and ITO (e.g., ITO/Al/ITO), APC, or a stack of APC and ITO (e.g., ITO/APC/ITO). When the anode electrodes 241 include a semi-transmissive conductive material, light extraction efficiency may be improved through a micro cavity effect.

The encapsulation layer 205 is formed on the light-emitting element layers 204. The encapsulation layer 205 serves to reduce or prevent oxygen or moisture from penetrating the light-emitting layers 242 and the cathode electrode 243. To this end, the encapsulation layer 205 may include at least one inorganic film. The inorganic film may be formed of silicon nitride, aluminum nitride, zirconium nitride, titanium nitride, hafnium nitride, tantalum nitride, silicon oxide, aluminum oxide, or titanium oxide. The encapsulation layer 205 may further include at least one organic film. The organic film may have a sufficient thickness to reduce or prevent foreign particles penetrating the encapsulation layer 205 and reaching the light-emitting layers 242 and the cathode electrode 243. The organic film may include one of epoxy, acrylate, or urethane acrylate.

A sensor unit SENL may be formed on the encapsulation layer 205. When the sensor unit SENL is formed directly on the encapsulation layer 205, the overall thickness of the display device 10 may be reduced compared to when a separate touch panel is attached on the encapsulation layer 205.

The sensor unit SENL may include sensor electrodes for detecting the user's touch input, touch wirings connecting pads and the sensor electrodes in a static capacitance scheme. For example, the sensor unit SENL may detect the user's touch input through a self-capacitance scheme or a mutual capacitance scheme. In FIG. 4, the sensor unit SENL is illustrated as being formed in a two-layer mutual capacitance scheme that includes driving electrodes TE, sensing electrodes RE, and connection portions BE connecting the driving electrodes TE.

The connection portions BE may be formed on the encapsulation layer 205. The connection portions BE may include laminated structure, such as a stack of Al and Ti (e.g., Ti/Al/Ti), a stack of Al and ITO (e.g., ITO/Al/ITO), APC, or a stack of APC and ITO (e.g., ITO/APC/ITO). Alternatively, the connection portions BE may include a single layer of Mo, Ti, Cu, Al, or ITO.

A first sensing insulating film TINS1 may be formed on the connection portions BE. The first sensing insulating film TINS1 may include an inorganic film, such as a silicon nitride layer, a silicon oxynitride layer, a silicon oxide layer, a titanium oxide layer, or an aluminum oxide layer.

The driving electrodes TE and the sensing electrodes RE may be formed on the first sensing insulating film TINS1. The driving electrodes TE and the sensing electrodes RE may include a stack of Al and Ti (e.g., Ti/Al/Ti), a stack of Al and ITO (e.g., ITO/Al/ITO), APC, or a stack of APC and ITO (e.g., ITO/APC/ITO), but the present invention is not limited thereto. Alternatively, the driving electrodes TE and the sensing electrodes RE may include a single layer of Mo, Ti, Cu, Al, or ITO.

Contact holes may be formed in the first sensing insulating film TINS1 to expose the connection portions BE through the first sensing insulating film TINS1. The driving electrodes TE may be connected to the connection portions BE through the contact holes.

A second sensing insulating film TINS2 may be formed on the driving electrodes TE and the sensing electrodes RE. The second sensing insulating film TINS2 may serve to planarize step differences caused by the driving electrodes TE, the sensing electrodes RE, and the connection portions BE. The second sensing insulating film TINS2 may include an organic film, such as acryl resin, epoxy resin, phenolic resin, polyamide resin, or polyimide resin.

The connection portions BE connecting adjacent driving electrodes TE may be positioned on the encapsulation layer 205, and the driving electrodes TE and the sensing electrodes RE may be positioned on the first sensing insulating film TINS1. Thus, the driving electrodes TE and the sensing electrodes RE are electrically isolated at their intersections. The sensing electrodes RE may be electrically connected in one direction, and the driving electrodes TE may be electrically connected in the other direction.

The polarizing film PF may be positioned on the second sensing insulating film TINS2 and may serve to reduce or prevent degradation of image visibility of the display panel 200 due to external light reflection.

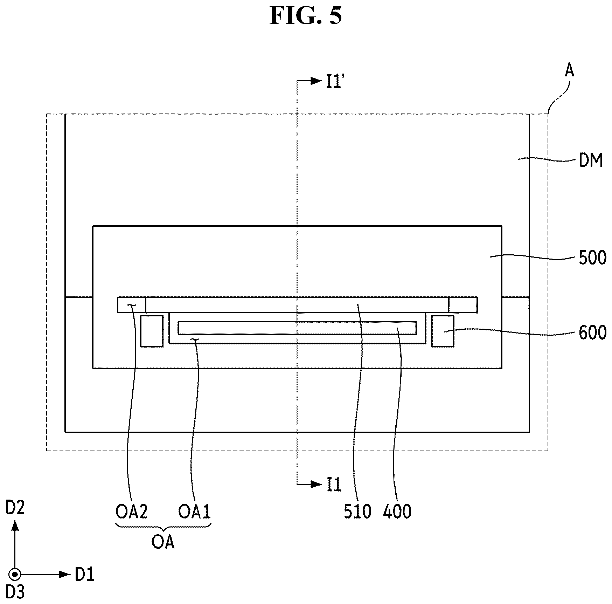

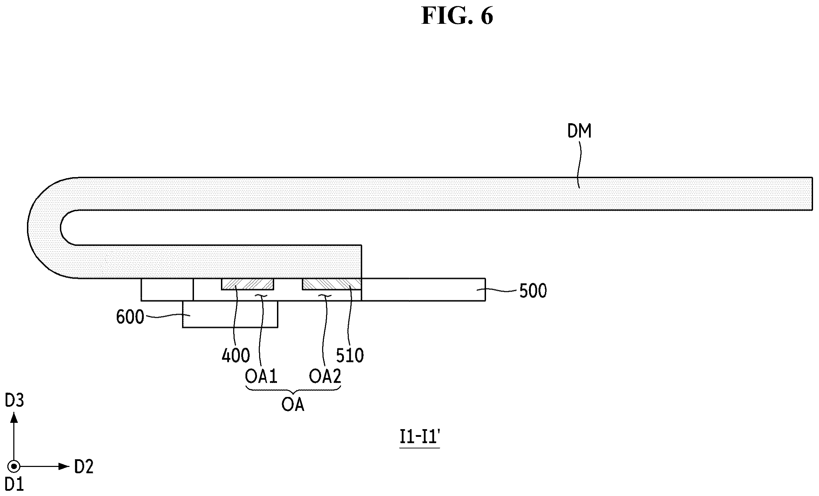

FIG. 5 is an enlarged plan view of portion A in FIG. 2. FIG. 6 is a cross-sectional view taken along the line I1-I1' of FIG. 5.

Referring to FIGS. 5 and 6, the driving circuit 400 may be positioned on the display module DM (as used herein, and in the clams, "positioned on" or "on" may mean "above" or "below"). The driving circuit 400 may be electrically connected to the display panel 200 of the display module DM. The driving circuit 400 may generate and output data voltages, power supply voltages, scan timing signals, and the like. The driving circuit 400 may extend in the first direction D1 on the display module DM.

The circuit board 500 may be positioned on the display module DM to overlap a portion of the display module DM. The circuit board 500 may be electrically connected to the display panel 200 of the display module DM. The circuit board 500 may be a flexible printed circuit board (FPCB), a rigid printed circuit board (PCB) that is stiff and not easily bent, or a composite PCB including both a rigid PCB and an FPCB. When the display module DM is bent, the circuit board 500 may overlap a panel lower member 300 of the display module DM. In one or more embodiments, the circuit board 500 may process signals converted by a control circuit board and deliver the processed signals to the display panel 200.

An open area OA overlapping the driving circuit 400 may be formed in the circuit board 500. The open area OA may be formed as a hole penetrating the circuit board 500 in the thickness direction of the circuit board 500. The open area OA may include a first open area OA1 and a second open area OA2.

The first open area OA1 may overlap the driving circuit 400. The first open area OA1 may be formed in a shape corresponding to the planar shape of the driving circuit 400. For example, when the driving circuit 400 has a rectangular planar shape extending in the first direction D1, the first open area OA1 may also have a rectangular planar shape extending in the first direction D1. The planar area of the first open area OA1 may be larger than the planar area of the driving circuit 400. Accordingly, when viewed from the third direction D3 (e.g., in plan view), the driving circuit 400 may be located within the first open area OA1.

The second open area OA2 may be connected to the first open area OA1. The second open area OA2 may be connected to a side, in the second direction D2, of the first open area OA1. The second open area OA2 may extend in the first direction D1 from the side, in the second direction D2, of the first open area OA1. The length of the second open area OA2 in the first direction D1 may be greater than the length of the first open area OA1 in the first direction D1. The second open area OA2 may overlap the coupler 510 to be described below.

The coupler 510 may be connected to the circuit board 500 to couple the display module DM and the circuit board 500. While being connected to the circuit board 500, the coupler 510 may overlap the second open area OA2. In some embodiments, the coupler 510 may be connected to the circuit board 500 within the second open area OA2. One surface (e.g., the upper surface in FIG. 6) of the coupler 510 may contact the display module DM. In one or more embodiments, a separate adhesive layer may be positioned between the surface of the coupler 510 and the display module DM. The display module DM and the coupler 510 may be coupled by the adhesive layer positioned between the surface of the coupler 510 and the display module DM, and accordingly, the circuit board 500 connected to the coupler 510 may be coupled to the display module DM.

The buffers 600 may protrude in the thickness direction of the circuit board 500 on the circuit board 500. A plurality of buffers 600 may be spaced apart from each other with the first open area OA1 positioned therebetween. For example, among the plurality of buffers 600, one buffer 600 may be positioned near a first side (e.g., the left side in FIG. 5) of the first open area OA1 in the first direction D1, and another buffer 600 may be positioned near a second side (e.g., the right side in FIG. 5) of the first open area OA1 in the first direction D1.

The buffers 600 may include one material selected from among air cushion, Steel Use Stainless (SUS), polyethylene terephthalate (PET), and/or aluminum (Al), or a combination of two or more of these materials.

Because the buffers 600 protrude in the third direction D3 beyond the circuit board 500, the buffers 600 may absorb an external impact applied to the circuit board 500 from the third direction D3, thereby reducing or preventing damage to the driving circuit 400 and the circuit board 500.

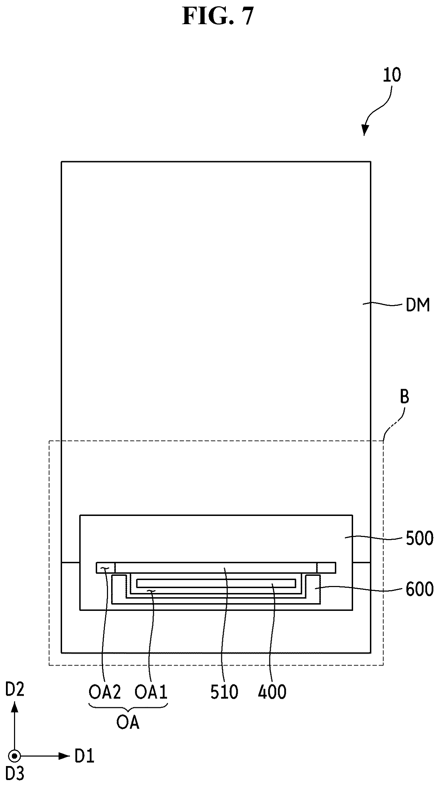

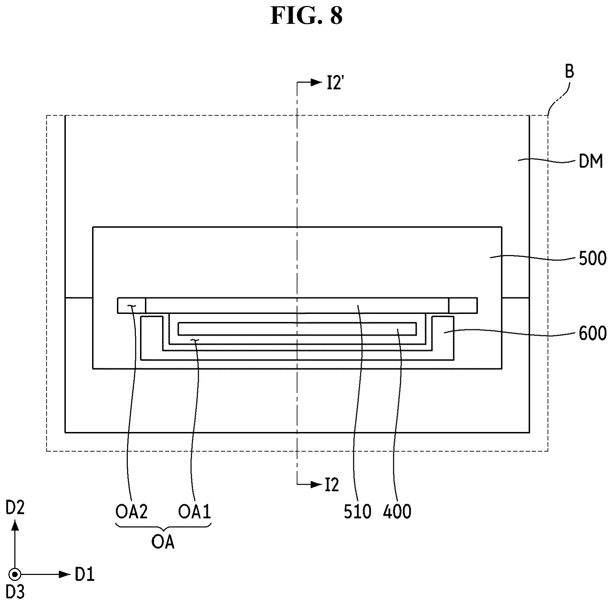

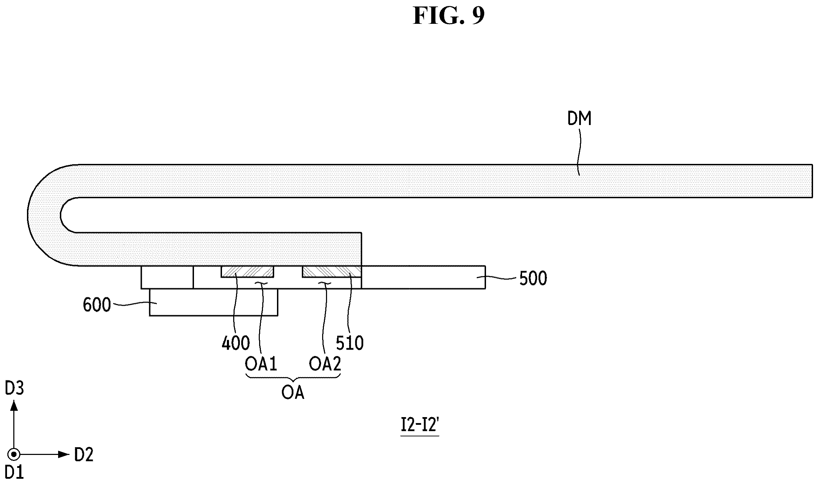

FIG. 7 is a plan view illustrating a display module of a display device according to second one or more embodiments of the present invention in a bent state. FIG. 8 is an enlarged plan view of portion B in FIG. 7. FIG. 9 is a cross-sectional view taken along the line I2-I2' of FIG. 8.

Referring to FIGS. 7 through 9, a display device 10 according to the second one or more embodiments of the present invention may include a display module DM, a driving circuit 400, a circuit board 500, a coupler 510, and a buffer 600.

The display module DM, the driving circuit 400, the circuit board 500, and the coupler 510 are the same as their respective counterparts of the first one or more embodiments, and thus, detailed descriptions thereof will be omitted.

The buffer 600 may protrude in the thickness direction of the circuit board 500 while being on the circuit board 500. The buffer 600 may surround (e.g., partially surround in plan view) the circumference of a first open area OA1. For example, the buffer 600 may extend in the second direction D2 on a first side (e.g., the left side in FIG. 8) of the first open area OA1 in the first direction D1 to surround (e.g., partially surround in plan view) the circumference on the first side of the first open area OA1, and may extend in the second direction D2 on a second side (e.g., the right side in FIG. 8) of the first open area OA1 in the first direction D1 to surround (e.g., partially surround in plan view) the second side of the first open area OA1. Additionally, the buffer 600 may extend from the first side to the second side of the first open area OA1 to surround (e.g., partially) the circumference of the first open area OA1 in the first direction D1.

The buffer 600 may include one material selected from among air cushion, SUS, PET, and/or AI, or a combination of two or more of these materials.

Because the buffer 600 protrudes in the third direction D3 beyond the circuit board 500, the buffer 600 may absorb an external impact applied to the circuit board 500 from the third direction D3, thereby reducing or preventing damage to the driving circuit 400 and the circuit board 500. In addition, because the buffer 600 surrounds the circumference of the first open area OA1, the buffer 600 may absorb even an external impact applied to the circuit board 500 from a direction between the second and third directions D2 and D3, thereby reducing or preventing damage to the driving circuit 400 and the circuit board 500.

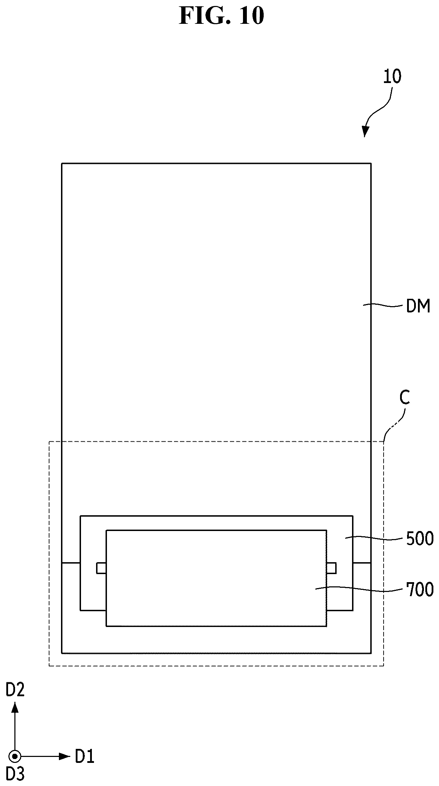

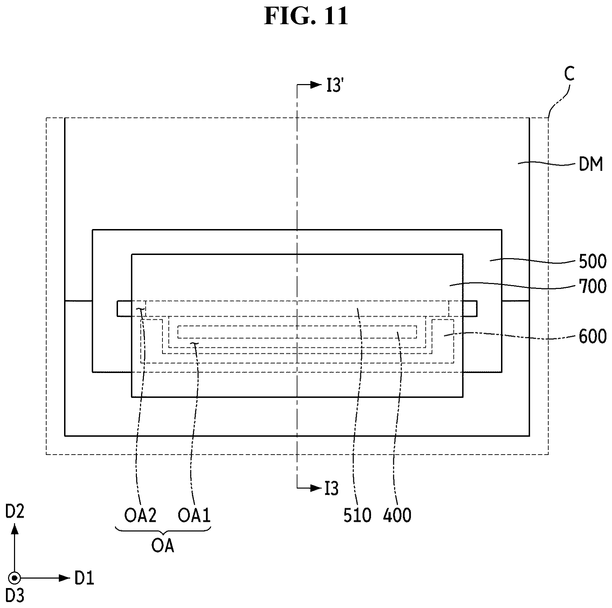

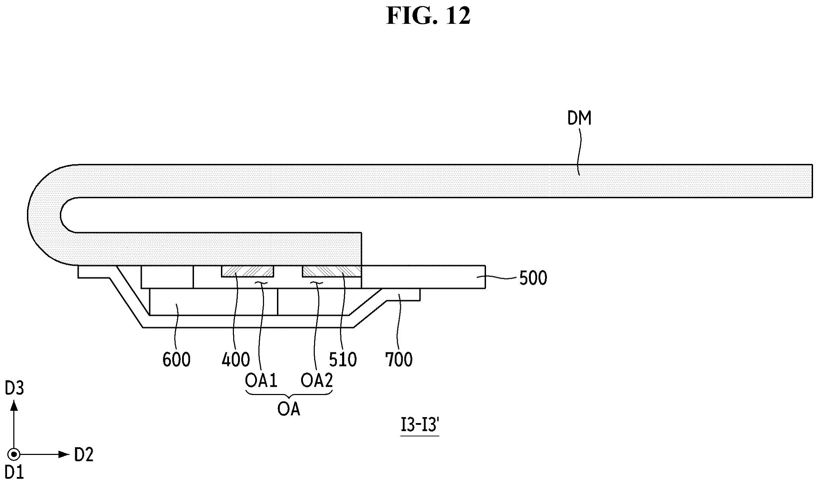

FIG. 10 is a plan view illustrating a state in which a cover (e.g., cover member) is placed in the display device in FIG. 7. FIG. 11 is an enlarged plan view of portion C of FIG. 10. FIG. 12 is a cross-sectional view taken along the line I3-I3' of FIG. 11.

Referring to FIGS. 10 through 12, the display device 10 may further include a cover 700.

The cover 700 may be positioned on the circuit board 500 so as to cover the driving circuit 400, the coupler 510, the buffer 600, and a portion of the open area OA. For example, the cover 700 may extend along the second direction D2 from the display module DM to the circuit board 500. The cover 700 may cover the entire buffer 600, may cover the entire first open area OA1 to cover the entire driving circuit 400, and may cover at least a portion of the second open area OA2 to cover the entire coupler 510. The length of the cover 700 in the first direction D1 may be greater than the length of the first open area OA1 in the first direction D1, and may be less than the length of the second open area OA2 in the first direction D1.

The cover 700 may include one material selected from among PET, a urethane-based sheet, copper, rubber, and/or polyethylene (PE) foam, or a combination of two or more of these materials. Because the cover 700 covers portions of the driving circuit 400 and the circuit board 500, the cover 700 may reduce or prevent damage to the driving circuit 400 or the circuit board 500 due to an external impact. In addition, the cover 700 may protect the driving circuit 400 from electrical stress, static electricity, and moisture.

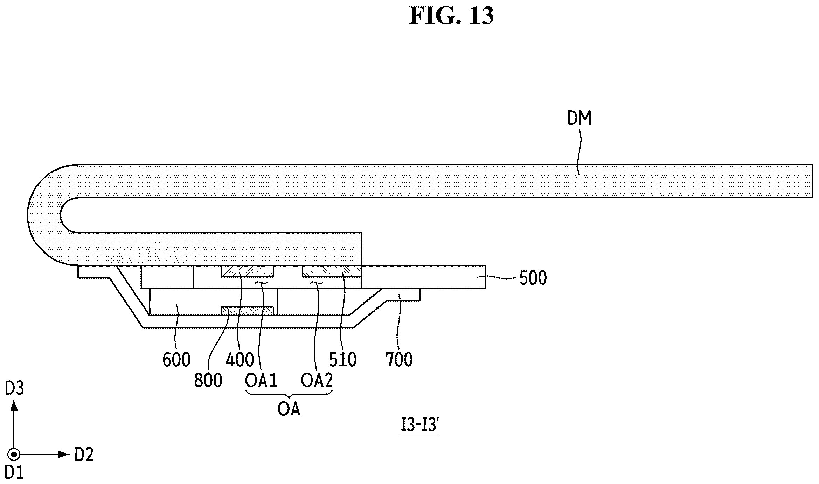

FIG. 13 is a cross-sectional view illustrating a state in which a heat dissipator (e.g., heat dissipation member) is placed in the display device in FIG. 12.

Referring to FIG. 13, the display device 10 may further include a heat dissipator 800.

The heat dissipator 800 may be positioned on the cover 700 to overlap the driving circuit 400. For example, the heat dissipator 800 may be positioned on an inner surface of the cover 700 to be covered by the cover 700. The inner surface of the cover 700 may be a surface of the cover 700 facing the driving circuit 400. The heat dissipator 800 may be positioned on the inner surface of the cover 700 to overlap the driving circuit 400 in the third direction D3. The planar shape of the heat dissipator 800 may follow the planar shape of the driving circuit 400. The heat dissipator 800 may be spaced apart from the driving circuit 400 in the third direction D3.

The heat dissipator 800 may include one material selected from among graphite, a thermal interface material (TIM), and/or metal injection molding (MIM), or a combination of two or more of these materials. By absorbing heat generated by the driving circuit 400, the heat dissipator 800 may reduce or minimize the transfer of the generated heat to the display module DM.

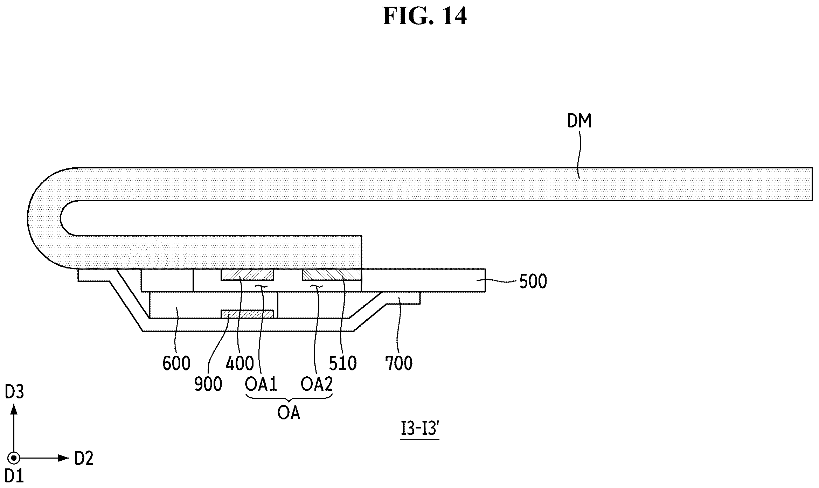

FIG. 14 is a cross-sectional view illustrating a state in which an auxiliary buffer is placed in the display device in FIG. 12.

Referring to FIG. 14, the display device 10 may further include an auxiliary buffer 900.

The auxiliary buffer 900 may be positioned on the cover 700 to overlap the driving circuit 400. For example, the auxiliary buffer 900 may be positioned on an inner surface of the cover 700 to be covered by the cover 700. The inner surface of the cover 700 may be a surface of the cover 700 facing the driving circuit 400. The auxiliary buffer 900 may be positioned on the inner surface of the cover 700 to overlap the driving circuit 400 in the third direction D3. The planar shape of the auxiliary buffer 900 may follow the planar shape of the driving circuit 400. The auxiliary buffer 900 may be spaced apart from the driving circuit 400 in the third direction D3.

The auxiliary buffer 900 may include one material selected from among SUS, PET, AI, urethane, and/or acrylic, or a combination of two or more of these materials. The auxiliary buffer 900 may absorb an external impact applied to the circuit board 500 from the third direction D3, thereby reducing or preventing damage to the driving circuit 400.

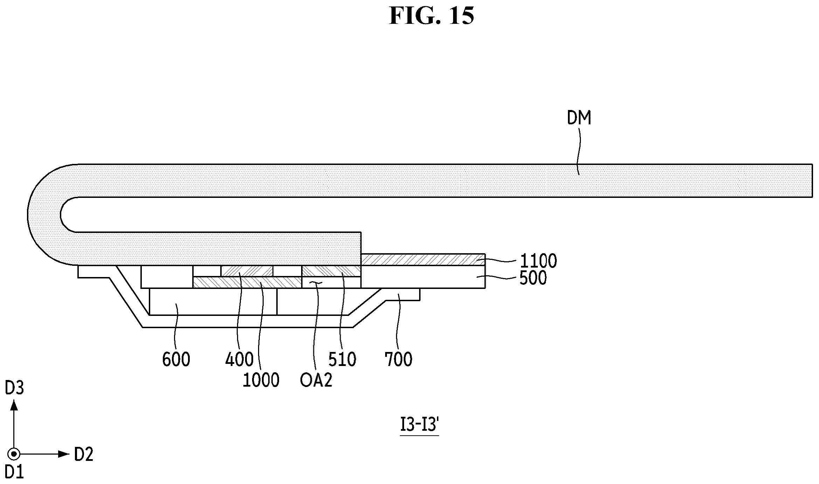

FIG. 15 is a cross-sectional view illustrating a state in which a circuit cover and an adhesive are placed in the display device in FIG. 12.

Referring to FIG. 15, the display device 10 may further include a circuit cover 1000 and an adhesive 1100.

The circuit cover 1000 may overlap the driving circuit 400. For example, the planar shape of the circuit cover 1000 may correspond to the planar shape of the first open area OA1, and may cover the entire first open area OA1. Because the circuit cover 1000 covers the entire first open area OA1, the driving circuit 400, which has a smaller planar area than the first open area OA1, may be entirely covered by the circuit cover 1000.

The circuit cover 1000 may contact the driving circuit 400 within the first open area OA1. Because the circuit cover 1000 contacts the driving circuit 400 and covers the entire driving circuit 400, the circuit cover 1000 may absorb an external impact applied to the circuit board 500 from the third direction D3, thereby reducing or preventing damage to the driving circuit 400. In one or more embodiments, the circuit cover 1000 may be provided as a conductive sheet having an adhesive layer formed only on a surface that contacts the driving circuit 400.

The adhesive 1100 may be positioned between the display module DM and the circuit board 500 to attach the display module DM and the circuit board 500 to each other. When the display module DM is bent, the adhesive 1100 may be positioned on a surface of the circuit board 500 facing the display module DM. In one or more embodiments, a separate adhesive layer may be positioned between the adhesive 1100 and the circuit board 500 to attach the adhesive 1100 and the circuit board 500, and another separate adhesive layer may be positioned between the adhesive 1100 and the display module DM to attach the adhesive 1100 and the display module DM. The adhesive 1100 may be attached to a panel lower member 300 of the display module DM.

The cover 700, the heat dissipator 800, the auxiliary buffer 900, the circuit cover 1000, and the adhesive 1100 have been described above as being included in the display device 10 of the second one or more embodiments, but the present invention is not necessarily limited thereto. The cover 700, the heat dissipator 800, the auxiliary buffer 900, the circuit cover 1000, and the adhesive 1100 may also be included in the display device 10 of the first one or more embodiments.

Display devices according to embodiments of the present invention may be applied to various electronic devices. An electronic device according to one or more embodiments may include the display device 10 of any one of the aforementioned embodiments and may further include modules or devices with additional functions other than the display device 10.

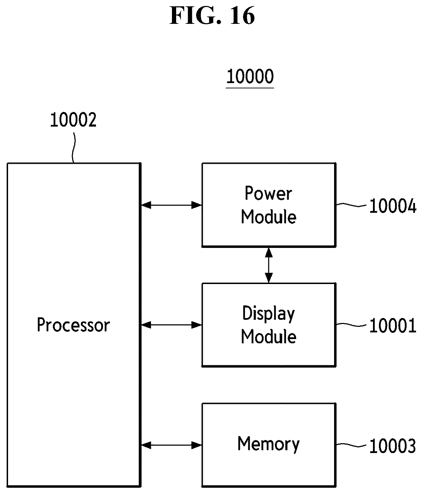

FIG. 16 is a block diagram of an electronic device according to one or more embodiments of the present invention.

Referring to FIG. 16, an electronic device 10000 according to one or more embodiments may include a display module 10001, a processor 10002, a memory 10003, and a power module 10004.

The processor 10002 may include at least one of a central processing unit (CPU), an application processor (AP), a graphics processing unit (GPU), a communication processor (CP), an image signal processor (ISP), or a controller.

The memory 10003 may store data and information required for the operation of the processor 10002 or the display module 10001. When the processor 10002 executes an application stored in the memory 10003, image data signals and/or input control signals may be delivered to the display module 10001, and the display module 10001 may process the received signals to output image information through a display screen.

The power module 10004 may include a power supply module, such as a power adapter or a battery device, and a power conversion module that converts power supplied by the power supply module into power required for the operation of the electronic device 10000.

At least one of the aforementioned components of the electronic device 10000 may be included in a display device according to any one of the aforementioned embodiments. Additionally, some of individual modules included functionally within a single module may be included in the display device, and others may be provided separately from the display device. For example, the display device may include the display module 10001, while the processor 10002, the memory 10003, and the power module 10004 may be provided as other devices included in the electronic device 10000.

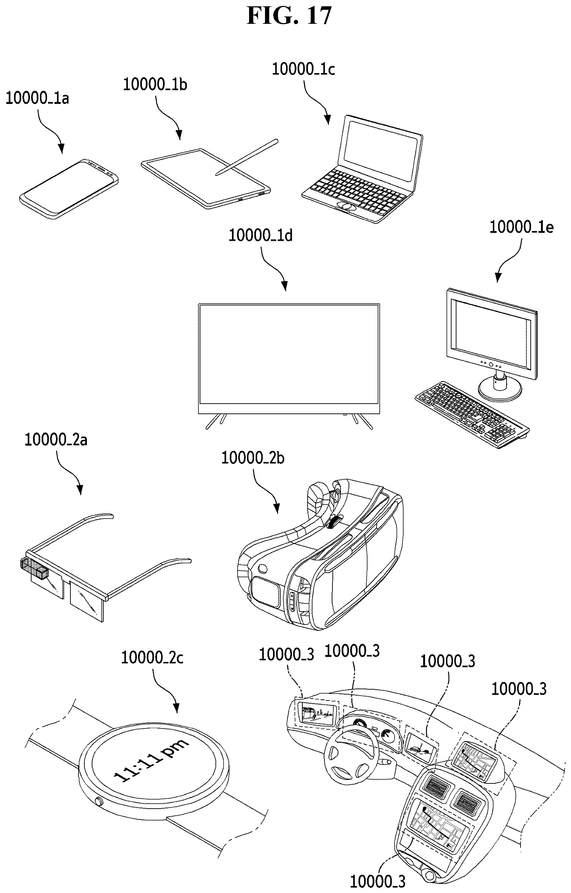

FIG. 17 illustrates schematic diagrams of electronic devices according to various embodiments.

Referring to FIG. 17, various electronic devices to which the display devices according to the embodiments are applied may include image display electronic devices, such as a smartphone 10000_1a, a tablet PC 10000_1b, a laptop 10000_1c, a TV 10000_1d, and a desktop monitor 10000_1 e, wearable electronic devices that include a display module, such as smart glasses 10000_2a, a head-mounted display 10000_2b, and a smart watch 10000_2c, and vehicle electronic devices 10000_3 that include a display module, such as a center information display (CID) arranged on the instrument panel, center fascia, or dashboard of a vehicle, and a room mirror display.

It should be understood, however, that the aspects and features of embodiments of the present invention are not restricted to the one set forth herein. The above and other aspects of the present invention will become more apparent to one of ordinary skill in the art to which the present invention pertains by referencing the claims.

## Claims

1. A display device (10) comprising:
a display module (DM);
a driving circuit (400) on the display module (DM);
a circuit board (500) on the display module (DM) and having an open area (OA) having a portion overlapping the driving circuit (400); and
a buffer (600) protruding in a thickness direction (D3) of the circuit board (500) on the circuit board (500).

2. The display device (10) of claim 1, further comprising a coupler (510) for coupling the display module (DM) and the circuit board (500),
wherein the open area (OA) comprises a first open area (OA1) overlapping the driving circuit (400), and a second open area (OA2) overlapping the coupler (510).

3. The display device (10) of claim 2, wherein the coupler (510) is connected to the circuit board (500) within the second open area (OA2).

4. The display device (10) of claim 2 or 3, further comprising buffers (600) spaced apart from each other with the first open area (OA1) therebetween.

5. The display device (10) of claim 4, wherein the first open area (OA1) extends in one direction (D1), and
wherein one of the buffers (600) is on one side of the first open area (OA1) in the one direction (D1), and another one of the buffers (600) is on another side of the first open area (OA1) in the one direction (D1).

6. The display device (10) of claim 5, wherein the one direction (D1) corresponds to a length direction of the driving circuit (400).

7. The display device (10) of claim 2 or 3, wherein the buffer (600) surrounds a circumference of the first open area (OA1) in plan view.

8. The display device (10) of at least one of claims 2 to 7, further comprising a cover (700) on the circuit board (500) to cover the driving circuit (400), the coupler (510), the buffer (600), and at least a portion of the open area (OA).

9. The display device (10) of claim 8, wherein the cover (700) extends from the display module (DM) to the circuit board (500).

10. The display device (10) of claim 8 or 9, wherein the cover (700) entirely covers the first open area (OA1) to cover the driving circuit (400) and covers at least a portion of the second open area (OA2) to cover the coupler (510).

11. The display device (10) of at least one of claims 8 to 10, further comprising a heat dissipator (800) overlapping the driving circuit (400) and on the cover (700) to be covered by the cover (700).

12. The display device (10) of claim 11, wherein the heat dissipator (800) is spaced apart from the driving circuit (400) in the thickness direction (D3) of the circuit board (500).

13. The display device (10) of at least one of claims 8 to 10, further comprising an auxiliary buffer (800) overlapping the driving circuit (400), and on the cover (700) to be covered by the cover (700).

14. The display device (10) of claim 13, wherein the auxiliary buffer (800) is spaced apart from the driving circuit (400) in the thickness direction (D3) of the circuit board (500).

15. The display device (10) of at least one of claims 8 to 10, further comprising a circuit cover (1000) overlapping the driving circuit (400), and within the first open area (OA1).

16. The display device (10) of claim 15, wherein the circuit cover (1000) corresponds to the first open area (OA1) and entirely covers the entire first open area (OA1).

17. The display device (10) of claim 15 or 16, wherein the circuit cover (1000) contacts the driving circuit (400).

18. The display device (10) of at least one of claims 1 to 17, further comprising an adhesive (1100) between the circuit board (500) and the display module (DM) to attach the circuit board (500) and the display module (DM) to each other.

19. An electronic device comprising:
a display device (10) according to at least one of claims 1 to 18.

20. The electronic device (10000) of claim 19, further comprising:
a processor (10002);
a memory (10003) configured to store data of of the display module (DM) and/or the processor (10002); and
a power module (10004) configured to supply power to the display module (DM), the processor (10002), and the memory (10003).
